# EUROPEAN PATENT SPECIFICATION

(11) **EP 1 149 519 B1**
(45) Date of publication and mention of the grant of the patent: **03.11.2004**
(21) Application number: 99949617.7
(22) Date of filing: 09.09.1999
(51) Int. Cl.: H05K 7/20

(54) **METHOD OF APPLYING A PHASE CHANGE THERMAL INTERFACE MATERIAL**
VERFAHREN ZUM ANBRINGEN EINES THERMISCHEN PHASENVERÄNDERLICHEN VERBINDUNGSMATERIALS
PROCEDE PERMETTANT D'APPLIQUER UN MATERIAU D'INTERFACE THERMIQUE A CHANGEMENT DE PHASE

(30) Priority: 15.12.1998 US 212111
(43) Date of publication of application: 31.10.2001
(73) Proprietor: Parker Hannifin Corporation, Cleveland, OH 44124-4141 (US)
(72) Inventor: BUNYAN, Michael, H., Chelmsford, MA 01824 (US); WATCHKO, George, R., Stoneham, MA 02180 (US); DEMASI, John, A., Chapel Hills, NC 27514 (US)
(74) Representative: Pilch, Adam John Michael
(86) International application number: PCT/US1999/020750
(87) International publication number: WO 2000/036893

(56) References cited:
- WO-A-97/41599

## Description

### CROSS-REFERENCE TO RELATED APPLICATION

This application is a continuation-in-part of U.S. application Serial No. 08/801,047, filed February 14, 1997, and entitled "Conformal Thermal Interface Material For Electronic Components," the disclosure of which is expressly incorporated herein by reference.

### BACKGROUND OF THE INVENTION

The present invention relates broadly to a phase change, thermal interface material which is interposable between, for example, the heat transfer surfaces of a heat-generating, electronic component and a thermal dissipation member, such as a heat sink or circuit board, for the conductive cooling of the electronic component, see e.g. WO 9741599. More particularly, the invention relates to the spray application of such material to the heat transfer surface of the component or dissipation member to achieve a relatively thin film thickness thereon which minimizes the thermal impedance between the component and dissipation member.

Circuit designs for modem electronic devices such as televisions, radios, computers, medical instruments, business machines, communications equipment, and the like have become increasingly complex. For example, integrated circuits have been manufactured for these and other devices which contain the equivalent of hundreds of thousands of transistors. Although the complexity of the designs has increased, the size of the devices has continued to shrink with improvements in the ability to manufacture smaller electronic components and to pack more of these components in an ever smaller area.

As electronic components have become smaller and more densely packed on integrated boards and chips, designers and manufacturers now are faced with the challenge of how to dissipate the heat which is ohmiciy or otherwise generated by these components. Indeed, it is well known that many electronic components, and especially power semiconductor components such as transistors and microprocessors, are more prone to failure or malfunction at high temperatures. Thus, the ability to dissipate heat often is a limiting factor on the performance of the component.

Electronic components within integrated circuit traditionally have been cooled via forced or convective circulation of air within the housing of the device. In this regard, cooling fins have been provided as an integral part of the component package or as separately attached thereto for increasing the surface area of the package exposed to convectively-developed air currents. Electric fans additionally have been employed to increase the volume of air which is circulated within the housing. For high power circuits and the smaller but more densely packed circuits typical of current electronic designs, however, simple air circulation often has been found to be insufficient to adequately cool the circuit components.

Heat dissipation beyond that which is attainable by simple air circulation may be effected by the direct mounting of the electronic component to a thermal dissipation member such as a "cold plate" or other heat sink. The heat sink may be a dedicated, thermally-conductive metal plate, or simply the chassis or circuit board of the device. However, beyond the normal temperature gradients between the electronic component and the heat sink, an appreciable temperature gradient is developed as a thermal interfacial impedance or contact resistance at the interface between the bodies.

That is, and as is described in U.S. Patent No. 4,869,954, the faying thermal interface surfaces of the component and heat sink typically are irregular, either on a gross or a microscopic scale. When the interfaces surfaces are mated, pockets or void spaces are developed therebetween in which air may become entrapped. These pockets reduce the overall surface area contact within the interface which, in turn, reduces the heat transfer area and the overall efficiency of the heat transfer through the interface. Moreover, as it is well known that air is a relatively poor thermal conductor, the presence of air pockets within the interface reduces the rate of thermal transfer through the interface.

To improve the heat transfer efficiency through the interface, a layer of a thermally-conductive, electrically-insulating material typically is interposed between the heat sink and electronic component to fill in any surface irregularities and eliminate air pockets. initially employed for this purpose were materials such as silicone grease or wax filled with a thermally-conductive filler such as aluminum oxide. Such materials usually are semi-liquid or solid at normal room temperature, but may liquefy or soften at elevated temperatures to flow and better conform to the irregularities of the interface surfaces.

For example, U.S. Patent Nos. 4,473,113 and 4,299,715 disclose a wax-like, heat-conducting material which is combined with another heat-conducting material, such as a beryllium, zinc, or aluminum oxide powder, to form a mixture for completing a thermally-conductive path from a heated element to a heat sink. A preferred wax-like material is a mixture of ordinary petroleum jelly and a natural or synthetic wax, such as beeswax, palm wax, or mineral wax, which mixture melts or becomes plastic at a temperature above normal room temperature. The material can be excoriated or ablated by marking or rubbing, and adheres to the surface on which it was rubbed. In this regard, the material may be shaped into a rod, bar, or other extensible form which may be carried in a pencil-like dispenser for application.

U.S. Patent No. 3,928,907 discloses a method of optimizing thermal conduction between a heat source such as a transistor, and a porous, laminated wire mesh heat sink by providing an interface mounting pad of a high thermal conductivity metal. The pad is built up by flame spraying molten metal particles of copper onto the porous metal surface.

U.S. Patent No. 4,466,483 discloses a thermally-conductive, electrically-insulating gasket. The gasket includes a web or tape which is formed of a material which can be impregnated or loaded with an electrically-insulating, heat conducting material. The tape or web functions as a vehicle for holding the meltable material and heat conducting ingredient, if any, in a gasket-like form. For example, a central layer of a solid plastic material may be provided, both sides of which are coated with a meltable mixture of wax, zinc oxide, and a fire retardant.

U.S. Patent No. 4,473,113 discloses a thermally-conductive, electrically-insulating sheet for application to the surface of an electronic apparatus. The sheet is provided as having a coating on each side thereof a material which changes state from a solid to a liquid within the operating temperature range of the electronic apparatus. The material may be formulated as a meltable mixture of wax and zinc oxide.

U.S. Patent No. 4,764,845 discloses a thermally-cooled electronic assembly which includes a housing containing electronic components. A heat sink material fills the housing in direct contact with the electronic components for conducting heat therefrom. The heat sink material comprises a paste-like mixture of particulate microcrystalline material such as diamond, boron nitride, or sapphire, and a filler material such as a fluorocarbon or paraffin.

U.S. Patent Nos. 5,250,209 and 5,167,851 disclose a water-soluble, thermally-conductive grease useful for the thermal coupling of electronic chips and heat sinks. The thixotropic, dielectric grease comprises a hydrophilic liquid polymer carrier and a microparticulate, thermally-conductive filler.

The greases and waxes of the aforementioned types heretofore known in the art, however, generally are not self-supporting or otherwise form stable at room temperature and are considered to be messy to apply to the interface surface of the heat sink or electronic component. To provide these materials in the form of a film which often is preferred for ease of handling, a substrate, web, or other carrier must be provided which introduces another interface layer in or between which additional air pockets may be formed. Moreover, use of such materials typically involves hand application or lay-up by the electronics assembler which increases manufacturing costs.

Alternatively, another approach is to substitute a cured, sheet-like material or pad for the silicone grease or wax material. Such materials may be compounded as containing one or more thermally-conductive particulate fillers dispersed within a polymeric binder, and may be provided in the form of cured sheets, tapes, pads, or films. Typical binder materials include silicones, urethanes, thermoplastic rubbers, and other elastomers, with typical fillers including aluminum oxide, magnesium oxide, zinc oxide, boron nitride, and aluminum nitride.

Exemplary of the aforesaid interface materials is an alumina or boron nitride-filled silicone or urethane elastomer which is marketed under the name CHO-THERM® by the Chomerics Division of Parker-Hannifin Corp., 77 Dragon Court, Wobum, MA 01888. Additionally, U.S. Patent No. 4,869,954 discloses a cured, form-stable, sheet-like, thermally-conductive material for transferring thermal energy. The material is formed of a urethane binder, a curing agent, and one or more thermally conductive fillers. The fillers, which may include aluminum oxide, aluminum nitride, boron nitride, magnesium oxide, or zinc oxide, range in particle size from about 1-50 microns (0.05-2 mils).

U.S. Patent No. 4,606,962 discloses an electrically and thermally conductive adhesive transfer tape for attaching individual semiconductor dies or chips to conductive substrates. The transfer tape comprises a flexible, low-adhesion carrier web to which is lightly adhered a layer of an adhesive containing electrically and thermally conductive particles. The particle containing adhesive layer is removed from the carrier web and compressed between the die and the substrate for attaching the die to the substrate.

U.S. Patent No. 4,654,754 discloses a "thermal link" for providing a thermal pathway between a heat source and a heat sink. In one embodiment, a thermally conductive elastomeric material, such as a silicone filled with silver-copper particles, is formed into a mat having a plurality of raised sections. The raised sections deform under low pressure to conform to the space between the heat source and the heat sink.

U.S. Patent No. 4,782,893 discloses a thermally-conductive, electrically-insulative pad for placement between an electronic component and its support frame. The pad is formed of a high dielectric strength material in which is dispersed diamond powder. In this regard, the diamond powder and a liquid phase of the high dielectric strength material may be mixed and then formed into a film and cured. After the film is formed, a thin layer thereof is removed by chemical etching or the like to expose the tips of the diamond particles. A thin boundary layer of copper or other metal then is bonded to the top and bottom surfaces of the film such that the exposed diamond tips extend into the surfaces to provide pure diamond heat transfer paths across the film. The pad may be joined to the electronic component and the frame with solder or an adhesive.

U.S. Patent Nos. 4,842,911; 4,685,987; and 4,602,678 disclose a composite interfacing for the withdrawal and dissipation of heat from an electronic, solid-state device by an associated heat sink. The interfacing consists of dual layers of a compliant silicone rubber carried on either side of a porous glass cloth. The layers are filled with finely-divided heat-conducting particles which may be formed of alumina or another metal oxide, or an electrically-conductive material such as nickel or graphite. One of the silicone layers is pre-vulcanized, with the other being cured and bonded in place once the interfacing has been applied to the heat sink surface for abutment with the electronic device.

Commonly-assigned U.S. Patent No. 4,869,954 discloses a form-stable material for use in transferring thermal energy from an electronic component to a heat sink. The material is formulated as the reaction product of a urethane resin and a curing agent, and is filled with one or more thermally conductive fillers such as zinc oxide, aluminum oxide, magnesium oxide, aluminum nitride, or boron nitride. The material may be formed as including a support layer of a glass cloth, plastic mesh or film, or a metal mesh or foil.

U.S. Patent No. 4,965,699 discloses a printed circuit device which includes a memory chip mounted on a printed circuit card. The card is separated from an associated cold plate by a layer of a silicone elastomer which is applied to the surface of the cold plate.

U.S. Patent No. 4,974,119 discloses a heat sink assembly which includes an electronic component supported on a printed circuit board in a spaced-apart relationship from a heat dispersive member. A thermally-conductive, elastomeric layer is interposed between the board and the electronic component. The elastomeric member may be formed of silicone and preferably includes a filler such as aluminum oxide or boron nitride.

U.S. Patent No. 4,979,074 discloses a printed circuit board device which includes a circuit board separated from a thermally-conductive plate by a pre-molded sheet of silicone rubber. The sheet may be loaded with a filler such as alumina or boron nitride.

U.S. Patent No. 5,060,114 discloses a conformable, gel-like pad having a thermally-conductive filler for conducting heat away from a packaged electronic power device. The pad is formed of a cured silicone resin which is filled with a thermally-conductive material such as aluminum powder, nickel, aluminum oxide, iron oxide, beryllium oxide, or silver. A thin sheet of a thermally-conductive metal such as aluminum is positioned in contact with the surface of the conformable pad for increased thermal transfer.

Commonly-assigned U.S. Patent No. 5,137,959 discloses a thermally-conductive, electrically insulating interface material comprising a thermoplastic or cross linked elastomer filled with hexagonal boron nitride or alumina. The material may be formed as a mixture of the elastomer and filler, which mixture then may be cast or molded into a sheet or other form.

U.S. Patent No. 5,151,777 discloses an interface device of thermally coupling an integrated circuit to a heat sink. The device includes a first material, such as copper, having a high thermal conductivity, which is provided to completely surround a plurality of inner core regions. The inner core regions contain a material such as an iron-nickel alloy having a low coefficient of thermal expansion.

Commonly-assigned U.S. Patent No. 5,194,480 discloses another thermally-conductive, electrically-insulating filled elastomer. A preferred filler is hexagonal boron nitride. The filled elastomer may be formed into blocks, sheets, or films using conventional methods.

Commonly-assigned U.S. Patent Nos. 5,213,868 and 5,298,791 disclose a thermally-conductive interface material formed of a polymeric binder and one or more thermally-conductive fillers. The fillers may be particulate solids, such as aluminum oxide, aluminum nitride, boron nitride, magnesium oxide, or zinc oxide. The material may be formed by casting or molding, and preferably is provided as a laminated acrylic pressure sensitive adhesive (PSA) tape. At least one surface of the tape is provided as having channels or through-holes formed therein for the removal of air from between that surface and the surface of a substrate such as a heat sink or an electronic component.

U.S. Patent No. 5,309,320 discloses a "conduction converter" for a printed circuit board having electronic components. The converter includes a body of a thermally conductive dielectric material, such as an alumina-filled RTV silicone, which is molded to the exact configuration of the electronic components. The converter may be clamped intermediate a cold plate and the circuit board to conductively remove heat from the electronic components.

U.S. Patent No. 5,321,582 discloses an electronic component heat sink assembly which includes a thermally-conductive laminate formed of polyamide which underlies a layer of a boron nitride-filled silicone. The laminate is interposed between the electronic component and the housing of the assembly.

Commonly-assigned U.S. Patent No. 5,510,174 discloses a thermally-conductive, titanium diboride (TiB₂) filler providing improved thermal conductivity at low application pressures. The filler may be incorporated into elastomers, films, and tapes.

U.S. Patent No. 5,545,473 discloses a thermally conductive interface for electronic components. The interface is formed of an open structure fluoropolymer material such as an expanded polytetrafluoroethylene. Thermally conductive particles, which may be formed of a metal or metal oxide, or another material such as boron nitride, aluminum nitride, diamond powder, or silicone carbide, are attached to portions of the fluoropolymer material.

U.S. Patent Nos. 5,533,256 and 5,471,027 disclose a method of joining a multi-layered ceramic (MLC) electronic package. The method involves the use of a double-sided, pressure-sensitive, thermally-conductive adhesive tape to directly bond the heat sink to an upper, exposed surface of the chip as mounted on a circuit board.

U.S. Patent No. 5,679,457 discloses a mechanically conformable, thermally-conductive interface for use in connecting printed circuit boards to heat sinks, metal chassises, or heat spreaders. The interface is formed of a silicone polymer of controlled molecular weight which is loaded filled with alumina, boron nitride, or another thermally-conductive, electrically insulating particulate filler. A surface layer of a pressure sensitive adhesive may be applied to the interface, with a release film being provided as an undersurface layer.

International Publication No. WO 96/37915 discloses an electronic assembly including an active circuit having surface mount components, an insulating layer, and an aluminum heat sink. The insulating layer comprises an unfilled thermoplastic sheet having adhesive layers on opposite sides thereof. The adhesive layers preferably are selected as a thermoplastic or thermosetting adhesive or pressure sensitive adhesive formulation containing a thermally-conductive and, optionally, electrically-conductive filler material which may be a metallic, inorganic, or ceramic particulate. The unfilled sheet preferably is a thin film of an engineering thermoplastic such as a polyester, polyetherimides, polyimide, or the like. A preferred adhesive is a solvent-borne, water-based, or hot melt thermoplastic adhesive.

Sheets, pads, and tapes of the above-described types have garnered general acceptance for use as interface materials in the conductive cooling of electronic component assemblies such as the semiconductor chips, i.e., dies, described in U.S. Patent No. 5,359,768. In certain applications, however, heavy fastening elements such as springs, clamps, and the like are required to apply enough force to conform these materials to the interface surfaces in order to attain enough surface for efficient thermal transfer. Indeed, for some applications, materials such as greases and waxes which liquefy, melt, or soften at elevated temperature continue to be preferred as better conforming to the interface surfaces under relatively low clamping pressures.

Recently, phase change materials have been introduced which are self-supporting and form-stable at room temperature for ease of handling, but which liquefy or otherwise soften at temperatures within the operating temperature range of the electronic component to form a viscous, thixotropic phase which better conforms to the interface surfaces. These phase change materials, which may be supplied as free-standing films, or as heated screen printed onto a substrate surface, advantageously function much like greases and waxes in conformably flowing within the operating temperature of the component under relatively low clamping pressures of about 5 psi (35 kPa). Such materials are further described in co-pending U.S. application Serial No. 08/801,047, filed February 14, 1997, and in counterpart International Publication No. WO 97/41599, and are marketed commercially under the names THERMFLOW™ T310, T705, and T710 by the Chomerics Division of Parker-Hannifin Corp., 77 Dragon Court, Woburn, MA 01888. Other phase change materials are marketed commercially by the Bergquist Company (Minneapolis, MN) under the tradename "HI-FLOW™," and by Orcus, Inc. (Stilwell, KS) under the tradename "THERMAPHASE."

It will be appreciated, however, that further improvements in phase change interface materials and in methods of applying the same would be well-received by the electronics industry. In this regard, it has been observed that many new heat sinks are manufactured has having close tolerances and machined-smooth heat transfer surfaces with variances in the range of only about 1-2 mil (0.025-0.05 mm). However, it is known that dry films within such thickness range are difficult to manufacture, handle, and cut. Especially desired therefore would be a method of applying a phase change thermal material to a heat transfer surface in a relatively thin film layer of between about 1-2 mil (0.025-0.05 mm). Such a layer would be thick enough to fill the gaps between the heat transfer surface and a mating heat transfer surface, but would minimize thermal impedance therebetween for improved heat transfer as compared to the thicker, i.e., 4-25 mil (0.1-0.63 mm), dry or screen printed films heretofore known in the art.

### BROAD STATEMENT OF THE INVENTION

The present invention is directed to a thermal interface material which is interposable between the faying heat transfer surfaces of a heat-generating, electronic component and a thermal dissipation member. The interface material is of a phase change variety which melts or otherwise softens at a temperature or range within the operating temperature range of the electronic component to better conform under relatively low clamping forces to the thermal interfaces for improved heat transfer from the electronic component to the thermal dissipation member. Unlike the greases or waxes of such type heretofore known in the art, however, the interface material of the present invention is form-stable and self-supporting at room temperature.

Advantageously, the material is applied as a fluent composition which is coated as an aerosol or atomized spray onto one or both of the heat transfer surfaces of the electronic component and dissipation member. Such application develops a relatively thin film layer, i.e., less than about 2 mil (0.05 mm), of the material on the heat transfer surface which minimizes the thermal impedance within the interface. The fluent composition may be applied using automated equipment to, for example, the interface surface of the thermal dissipation member which may be a plate fin, pin-fin, corrugated, or other heat sink. Alternatively, the formulation may be dispensed from a conventional aerosol spray can.

In accordance with the precepts of the present invention, the fluent composition is formulated as a solution, emulsion, dispersion, suspension, or other admixture of: (I) a phase change material (PCM) and; (II) a compatible diluent. In a preferred embodiment, the PCM comprises: (a) from about 25 to 50% by weight of a pressure sensitive adhesive (PSA) component having a melting temperature of from about 90-100°C; (b) from about 50 to 75% by weight of an α-olefinic, thermoplastic component having a melting temperature of from about 30-60°C; and (c) from about 20 to 80% by weight of one or more thermally-conductive fillers. The PCM is rendered fluent via its adjustment to about 10-30% total solids and a viscosity of between about 10-25 cps with the diluent which preferably is an organic solvent such as toluene, xylene, methyl ethyl ketone, methyl isobutyl ketone, naphtha, or a mixture thereof. Following the spray application of the composition onto one or both of the heat transfer surfaces of the electronic component and dissipation member, the solvent is evaporated or otherwise volatized such that a generally self-adherent, thin film layer of the PCM remains on the one or both of the heat transfer surfaces as the interface material.

It therefore is a feature of an illustrated embodiment of the present invention to provide a method for the application of a thermally-conducting, phase change material to a heat transfer surface within an assembly including a heat-generating electronic and a thermal dissipation member disposable in thermal adjacency with the electronic component to define an interface therebetween. The material is of a variety which is form-stable at normal room temperature in a first phase and conformable within the interface in a second phase, and has a transition temperature from the first phase to the second phase within the operating temperature range of the electronic component.

The phase change material is provided for application as a fluent, curable composition which is an admixture of the material and a diluent which may be an organic solvent. The fluent composition is sprayed onto the heat transfer surface to cover at least a portion thereof. The deposited composition then is cured, such as by volatilization or other evaporation of the diluent, to form a film layer of the phase change material on the heat transfer surface. Preferably, such film layer is less than 2 mil (0.5 mm) thick.

The present invention, accordingly, comprises the combination of elements and arrangement of parts and steps which are exemplified in the detailed disclosure to follow. Advantages of the present invention includes the application of a phase change thermal interface material which melts or otherwise softens for improved conformability, but which is self-supporting and form-stable at room temperature for ease of handling. Further advantages include applying a low thermal impedance, thin film layer of phase change thermal interface material to the heat transfer surface of an electronic component or thermal dissipation member. These and other advantages will be readily apparent to those skilled in the art based upon the disclosure contained herein.

### BRIEF DESCRIPTION OF THE DRAWINGS

For a fuller understanding of the nature and objects of the invention, reference should be had to the following detailed description taken in connection with the accompanying drawings wherein:
Fig. 1 is a fragmentary, cross-sectional view of an electrical assembly wherein a heat-generating electronic component thereof is conductively cooled in accordance with the present invention via the provision of a thin film interlayer of a thermally-conductive, phase change material within the thermal interface between the heat transfer surfaces of the component and an associated thermal dissipation member;
Fig. 2 is a magnified view of a portion of the phase change material of Fig. 1 showing the morphology thereof in enhanced detail;
Fig. 3 is a perspective, somewhat schematic view illustrative of the method of the present invention for the spray application of the phase change thermal interface material of Figs. 1 and 2 to the thermal dissipation member of Fig. 1; and
Fig. 4 is a cross-sectional view taken through the plane represented by line 4-4 of Fig. 3 showing the thermal interface material and dissipation member thereof as additionally including a protective release sheet covering the outward surface of the interface material.

The drawings will be described further in connection with the following Detailed Description of the Invention.

### DETAILED DESCRIPTION OF THE INVENTION

Certain terminology may be employed in the description to follow for convenience rather than for any limiting purpose. For example, the terms "upper" and "lower" designate directions in the drawings to which reference is made, with the terms "inner," "interior," or "inward," and "outer," "exterior," or "outward" referring, respectively, to directions toward and away from the center of the referenced element. Terminology of similar import other than the words specifically mentioned above likewise is to be considered as being used for purposes of convenience rather than in any limiting sense.

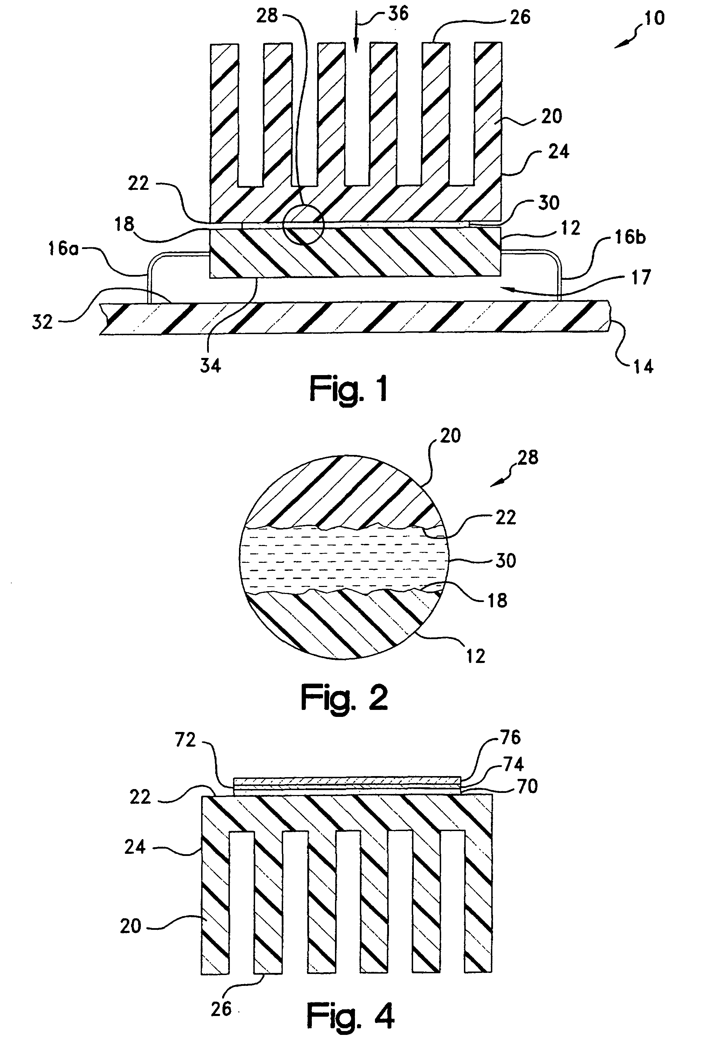

Referring to the drawings wherein corresponding reference characters indicate corresponding elements throughout the figures, shown generally at 10 in Fig. 1 is an electrical assembly which includes a heat-generating digital or analog electronic component, 12, supported on an associated printed circuit board (PCB) or other substrate, 14. Electrical component 12 may be an integrated microchip, microprocessor, transistor, or other power semiconductor device, an ohmic or other heat-generating subassembly such as a diode, relay, resistor, transformer, amplifier, diac, or capacitor, or, alternatively, another heat-generating source. Typically, component 12 will have an operating temperature range of from about 60-100°C. For the electrical connection of component 12 to board 14, a pair of leads or pins, 16a and 16b, are provided as extending from either end of component 12 into a soldered or other connection with board 14. Leads 16 additionally may support component 12 above board 14 to define a gap, represented at 17, of about 3 mils (75 microns) therebetween. Alternatively, component 12 may be received directly on board 14.

As supported on board 14, electronic component 12 presents a first heat transfer surface, 18, which is disposable in a thermal, spaced-apart adjacency with a corresponding second heat transfer surface, 22, of an associated thermal dissipation member, 20. Dissipation member 20 is constructed of a metal material or the like having a heat capacity relative to that of component 12 to be effective is dissipating thermal energy conducted or otherwise transferred therefrom. For purposes of the present illustration, thermal dissipation member 20 is shown as a heat sink having a generally planar base portion, 24, from which extends a plurality of cooling fins, one of which is referenced at 26. With assembly 10 configured as shown, fins 26 assist in the convective cooling of component 12, but alternatively may be received within an associated cold plate or the like, not shown, for further conductive dissipation of the thermal energy transferred from component 12.

The disposition of first heat transfer surface 18 of electronic component 12 in thermal adjacency with second heat transfer surface 22 of dissipation member 20 defines a thermal interface, represented at 28, therebetween. A thermally-conductive interfacing, 30, is interposed as an interlayer within interface 28 between heat transfer surfaces 18 and 22 for providing a conductive path therethrough for the transfer of thermal energy from component 12 to dissipation member 20. Such path may be employed without or in conjunction with convective air circulation for effecting the cooling of component 12 and ensuring that the operating temperature thereof is maintained below specified limits.

Although thermal dissipation member 20 is shown to be a separate heat sink member, board 14 itself may be used for such purpose by alternatively interposing interfacing 30 between surface 32 thereof and corresponding surface 34 of electronic component 12. In either arrangement, a retention clip, spring, or clamp or the like (not shown) additionally may be provided for securing dissipation member 20 to component 12 and for applying an external clamping pressure, represented at 32, of about 5 psi (35 kPa). Such pressure improves the interface area contact between interfacing 30 and the heat transfer surfaces 18 and 22 or 32 and 34.

In accordance with the precepts of the present invention, interfacing 30 is formed of a self-supporting film layer of a thermally-conductive, phase change material ("PCM"). By "self-supporting," it is meant that interfacing 30 is generally free-standing without the support of a web or substrate which would introduce another layer into the thermal interface between which air pockets could be formed. Preferably, the film of interfacing 30 will have a thickness between about 1-2 mils (0.025-0.5 mm), and preferably less than about 2 mils (0.05 mm).

The thermally-conductive PCM forming interfacing 30 is formulated to be form-stable at normal room temperature, i.e., about 25°C, in a first phase, which is solid, semi-solid, glassy, or crystalline, but to be substantially conformable in a second phase, which is a liquid, semi-liquid, or otherwise viscous, generally-thixotropic melt, to interface surfaces 18 and 22 of, respectively, electronic component 12 and thermal dissipation member 20. The phase transition temperature of the material, which may be its melting or glass transition temperature, is preferably between about 40-80°C, and is tailored to fall within the operating temperature of electronic component 12.

Further in this regard, reference may be had to Fig. 2 wherein an enlarged view of a portion of interface 28 is illustrated to detail the internal morphology thereof during the energization of electronic component 12 effective to heat interfacing 30 to a temperature which is above its phase transition temperature. Interfacing 30 accordingly is shown to have been melted or otherwise softened from a form-stable solid or semi-solid phase into a flowable or otherwise conformable liquid or semi-liquid viscous phase which may exhibit relative intermolecular chain movement. Such viscous phase provides increased surface area contact with interface surfaces 18 and 22, and substantially completely fills interface 28 via the exclusion of air pockets or other voids therefrom to thereby improve both the efficiency and the rate of heat transfer through interface. Moreover, as depending on, for example, the melt flow index or viscosity of interfacing 30 and the magnitude of any applied external pressure 36 (Fig. 1), the interface gap between surfaces 18 and 22 may be narrowed to further improve the efficiency of the thermal transfer therebetween. Any latent heat associated with the phase change of the material forming interfacing 30 additionally contributes to the cooling of component 12.

In one preferred embodiment, the PCM of interfacing 30 is formulated as a form-stable blend of: (a) between about 25% and about 50% by weight of a pressure sensitive adhesive (PSA) component having a melting temperature of between about 90-100°C; (b) between about 50% and about 75% by weight of an α-olefinic, thermoplastic component having a melting temperature of between about 30-60°C; and (c) between about 20% and 80% by weight of one or more thermally-conductive fillers. "Melting temperature" is used herein in its broadest sense, and as interchangeable with "melting point," "softening temperature," and "softening point" to indicate a transition from a form-stable crystalline or glassy solid phase to a flowable liquid, semi-liquid, or otherwise viscous, thixotropic phase or melt which may be generally characterized as exhibiting intermolecular chain rotation. In this regard, the specified components typically will exhibit the stated softening or melting points as determined by means of differential scanning calorimetry (DSC) or differential thermal analysis (DTA). For amorphous materials not having a clearly defined melting peak, the term melting temperature also is used interchangeably with glass transition point at which the such materials may be characterized as exhibiting intramolecular chain rotation.

The PSA component generally may be of an acrylic-based, hot-melt variety such as a homopolymer, copolymer, terpolymer, interpenetrating network, or blend of an acrylic or (meth)acrylic acid, an acrylate such as butyl acrylate or other alcohol ester, and/or an amide such as acrylamide. The term "PSA" is used herein in its conventional sense to mean that the component is formulated has having a glass transition temperature, surface energy, and other properties such that it exhibits some degree of tack at normal room temperature. Acrylic hot-melt PSAs of such type are marketed commercially by Heartland Adhesives, Germantown, WI, under the trade designations "H600" and "H251."

The α-olefinic thermoplastic component preferably is a polyolefin which may be characterized as a "low melt" composition. A representative material of the preferred type is an amorphous polymer of a C₁₀ or higher alkene which is marketed commercially by Petrolite Corporation, Tulsa, OK, under the trade designation "VYBAR® 260." Such material may be further characterized as is set forth in Table 1.

**Table 1**

| Physical Properties of Representative Olefinic Polymer Component (VYBAR®260) | |
|---|---|
| Molecular Weight | 2600 g/mol |
| | |
| Melting Point (ASTM D 36) | 130°F (54°C) |
| | |
| Viscosity(ASTM D 3236) @ 210°F (99°C) | 357.5 cP |
| | |
| Penetration (ASTM D 1321) @ 77°F (25°C) | 12 mm |
| | |
| Density (ASTM D 1168) | |
| | |
| @ 75°F (24°C) | 0.90 g/cm³ |
| @ 200°F (93°C) | 0.79 g/cm³ |
| | |
| Iodine Number (ASTM D 1959) | 15 |

By varying the ratio of the PSA to the thermoplastic component within the specified limits, the thermal and viscometric properties of the interfacing formulation may be tailored to provide controlled thermal and viscometric properties. In particular, the phase transition temperature and melt flow index or viscosity of the formulation may be selected for optimum thermal performance with respect to such variables as the operating temperature of the heat generating electronic component, the magnitude of any applied external pressure, and the configuration of the interface. Generally, a phase transition temperature of between about 40-80°C is considered preferred for the interface material of the present invention.

In the described formulation, the resin components form a binder into which the thermally-conductive filler is dispersed. The filler is included within the binder in a proportion sufficient to provide the thermal conductivity desired for the intended application. The size and shape of the filler is not critical for the purposes of the present invention. In this regard, the filler may be of any general shape including spherical, flake, platelet, irregular, or fibrous, such as chopped or milled fibers, but preferably will be a powder or other particulate to assure uniform dispersal and homogeneous mechanical and thermal properties. The particle size or distribution of the filler typically will range from between about 0.25-250 microns (.01-10 mil), but may further vary depending upon the thickness of interface 28 and/or interfacing 30. The filler preferably is selected as being electrically-nonconductive such that interfacing 30 may provide a dielectric or electrically-insulating, but thermally-conductive barrier between electronic component 12 and thermal dissipation member 20. Suitable thermally-conductive, electrically insulating fillers include boron nitride, titanium diboride, aluminum oxide, aluminum nitride, magnesium oxide, zinc oxide, silicon carbide, beryllium oxide, antimony oxide, and mixtures thereof. Such fillers characteristically exhibit a thermal conductivity of about 25-50 W/m-°K. For reasons of economy, an aluminum oxide, i.e., alumina, is especially preferred. With such thermally-conductive fillers, interfacing 30 typically will exhibit, as per ASTM D5470, a thermal conductivity of between about 0.1-1 W/m-°K and a thermal impedance of less than about 1 °C-in²/W (6 °C-cm²/W).

Additional fillers and additives may be included in the formulation depending upon the requirements of the particular application envisioned and to the extent that the thermal conductivity and electrical properties of the formulation are not compromised. Such fillers and additives may include conventional wetting agents or surfactants, opacifying or anti-foaming agents, chain extending oils, tackifiers, pigments, lubricants, stabilizers, flame retardants such as decabromodiphenyl oxide, and antioxidants. The formulation may be compounded in a conventional mixing apparatus.

in accordance with the precepts of the present invention, prior to its application to thermal dissipation member 20, the PCM of interfacing 30 is rendered fluent via its admixing with a diluent which may be an organic solvent such as toluene, xylene, methyl ethyl ketone, methyl isobutyl ketone, naphtha, or a mixture thereof. By "fluent," it is meant that the admixed composition, which may be a solution, emulsion, dispersion, suspension, or other mixture, exhibits representative fluid flow characteristics allowing it to be atomized or otherwise sprayed under pressure and at a given flow velocity through a dispensing nozzle or other orifice, which may have an opening of between about 0.04-0.06 inch (1-1.5 mm). Preferably, the composition is adjusted to about 10-30% total solids and a viscosity of between about 10-25 cps.

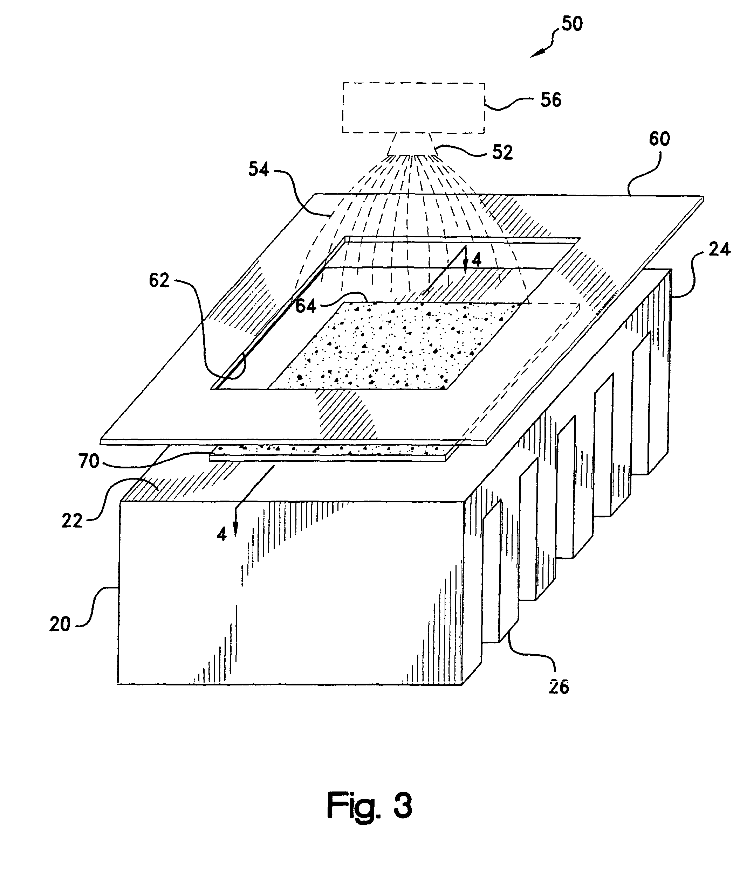

Referring next to Fig. 3, an illustrative spray application of the admixed PCM-diluent composition to a thermal dissipation member such as heat sink 20 of Fig. 1 is described in connection with the system shown at 50. System 50 includes a nozzle, 52, with an orifice of a select diameter, through which the composition is delivered onto the heat sink heat transfer surface 22 as the atomized or other spray stream referenced at 54. Nozzle 52 is provided to be in fluid communication with a material supply, represented in phantom by block 56, which may be part of an automated spray apparatus or, alternatively, an aerosol can.

For confining spray 54 to a select area of heat transfer surface 22, a removable mask, 60, optionally may be interposed between surface 22 and nozzle 52. Mask 60 is provided as having one or more apertures, one of which is referenced at 62, with margins corresponding to the desired outer periphery, referenced at 64, of interfacing 30 which is shown in Fig. 3 as the generally rectangular pad referenced at 70. Alternatively, the composition may be sprayed from nozzle 52 without the use of a mask 60 to cover substantially the entirety of surface 22.

So deposited onto surface 22, the composition may be cured to hardened or solidify into a form stable, generally self-adherent film by drying, volatilizing, or otherwise evaporating the diluent. In this regard, depending upon the diluent, the coated heat sink may be heated in an oven, furnace, or the like to an elevated temperature of between about 70-125°C effecting the volatilization of the diluent. Alternatively, the composition may be dried under ambient conditions or under conditions of reduced humidity to evaporate the diluent leaving a residue film of the PCM on surface 22. Film thicknesses of less than about 2 mil (0.05 mm) may be achieved using the spray application of the present invention.

Unlike greases or waxes, the cured pad 70 advantageously is form-stable at normal room temperature in a solid, semi-solid, crystalline, or glassy phase which is converted at elevated temperatures into a flowable liquid, semi-liquid, or otherwise viscous, thixotropic phase. In its form-stable phase, however, pad 70 and heat sink 20 may be shipped and handled without causing the PCM to slump, sag, or run, and thereby facilitates the attachment of heat sink 20 to its associated electronic component 12 (Fig. 1).

For further ease of use, and as may be seen with reference to Fig. 4, the exposed surface 72 of PCM pad 70 may be coated with a thin layer, 74, of a silicone, acrylic or other pressure sensitive adhesive to affix heat sink 20 to component 12 during installation. As is common in the adhesive arts, a release sheet, 76, may be provided as a strip of a waxed, siliconized, or other coated paper or plastic sheet or the like having a relatively low surface energy so as to be removable without appreciable lifting of pad 70 from surface 22. Representative release sheets include face stocks or other films of plasticized polyvinyl chloride, polyesters, cellulosics, metal foils, composites, and the like.

With pad 70 so applied and with release sheet 76 protecting the adhesive layer 74 thereof, heat sink 20 may be packaged and shipped as an integrated unit to an electronics manufacturer, assembler, or other user. The user then simply may remove release sheet 76 to expose the adhesive layer 74, position such layer on heat transfer surface 18 of electronic component 12 (Fig. 1), and lastly apply a clip or other another means of external pressure to heat sink 20 in thermal adjacency with component 12

The Example to follow, wherein all percentages and proportions are by weight unless otherwise expressly indicated, is illustrative of the practicing of the invention herein involved, but should not be construed in any limiting sense.

### EXAMPLE

A phase change thermal interface was prepared in accordance with the present invention for characterization. A commercial boron nitride (BN)-filled, form-stable PCM (THERMFLOW™ 705, Parker Chomerics, Woburn, MA) was thinned with organic solvents to about 15% total solids by weight to yield a fluent, liquid solution. The solution was sprayed using a packaged spray can with a ball agitator onto the bottom surface of a commercial 1.75 inch (4.5 cm) by 1.75 inch (4.5 cm), pin fin heat sink (Wakefield Engineering, Inc., Beverly, MA), and then dried to leave an adherent film residue having a thickness of about 2 mil (0.05 mm).

The heat sink so prepared was surface mounted using a clip under an application pressure of less than about 5 psi (35 kPa) to an Intel® Pentium® II 266 MHz microprocessor chip. Differential temperature measurements were obtained using thermocouples attached to the chip case and heat sink, with the ambient temperature within the computer also being measured. At steady-state, i.e., after about 40 minutes, final temperature measurements were recorded.

The experimental results, wherein all temperatures are in °C, are summarized in Table 2 as compared to the performance of a similar assembly incorporating a conventional dry film thermal interface material (THERMFLOW™ 705, Parker Chomerics) having a thickness of about 5 mil (0.125 mm).

**Table 2**

| Comparative Thermal Performance of Experimental Sprayed and Conventional Dry Film PCM Interfaces | | | | | |
|---|---|---|---|---|---|
| Sample | Thickness | T_{ambient} | T_{case} | Tₛᵢₙₖ | ΔT_{case-sink} |
| Sprayed | 2 mil (0.05 mm) | 35.0 | 54.15 | 53.72 | 0.43 |
| Dry | 5 mil (0.125 mm) | 34.0 | 53.65 | 53.7 | 0.65 |

The foregoing results confirm that a sprayed, thin film phase change thermal interface offers improved performance as compared to a thicker, conventional dry film. The interfaces of the present invention accordingly may be employed in high density, high frequency, or other critical service applications with a high degree of confidence.

As it is anticipated that certain changes may be made in the present invention without departing from the precepts herein involved, it is intended that all matter contained in the foregoing description shall be interpreted as illustrative and not in a limiting sense.

## Claims

1. In an assembly including a heat-generating electronic component having an operating temperature range above normal room temperature and a first heat transfer surface disposable in thermal adjacency with a second heat transfer surface of a thermal dissipation member to define an interface therebetween, a method of applying a thermally-conducting, phase change material to one or both of the first and second heat transfer surfaces, said material being form-stable at normal room temperature in a first phase and conformable within the interface to the first and the second interface surface in a second phase, and having a transition temperature from said first phase to said second phase within the operating temperature range of said electronic component, said method comprising the steps of:
(a) providing a fluent, curable composition comprising an admixture of: (I) said phase change material; and (II) a diluent;
(b) spraying said composition of step (a) onto said one of the heat transfer surfaces to cover at least a portion thereof; and
(c) curing said composition to form a film layer of said phase change material (I) on said one of the heat transfer surfaces.

2. The method of claim 1 further comprising an additional step prior to step (b) of removably masking said one of the heat transfer surfaces to confine the spray of step (b) to a select area thereof, and wherein said film layer is formed in step (c) as having margins corresponding to said select area.

3. The method of claim 1 wherein said composition is cured in step (c) by evaporating said diluent (II).

4. The method of claim 1 wherein said film layer is formed in step (c) as having a thickness of less than about 2 mils (0.05 mm).

5. The method of 4 wherein said film layer has a thermal impedance of less than about 1 °C-in²/W (6 °C-cm²/W).

6. The method of claim I wherein said composition of step (a) is between about 10-30% solids by weight.

7. The method of claim I wherein said phase change material (I) of step (a) comprises, by weight of components (i)-(iii):
(i) between about 25-50% by weight of an acrylic pressure sensitive adhesive component having a melting temperature of between about 90-100°C;
(ii) between about 50-75% by weight of an α-olefinic, thermoplastic component having a melting temperature of between about 30-60°C; and
(iii) between about 20-80% by weight of one or more thermally-conductive fillers.

8. The method of claim 7 wherein said phase material (1) has a phase transition temperature of between about 40-80°C.

9. The method of claim 7 wherein said one or more thermally-conductive fillers is selected from the group consisting of boron nitride, titanium diboride, aluminum oxide, aluminum nitride, magnesium oxide, zinc oxide, silicon carbide, beryllium oxide, antimony oxide, and mixtures thereof.

10. The method of claim 1 wherein said thermal dissipation member is a heat sink or a circuit board.

11. The method of claim 1 wherein said layer is applied in step (c) to the heat transfer surface of said electronic component.

12. The method of claim 1 wherein said diluent (II) is an organic solvent.

13. The method of claim 12 wherein said solvent is toluene, xylene, methyl ethyl ketone, methyl isobutyl ketone, naphtha, or a mixture thereof.

## Patentansprüche

1. In einer Baugruppe, die eine Wärme erzeugende elektronische Komponente mit einem Betriebstemperaturbereich über normaler Raumtemperatur und eine erste Wärmeübertragungsfläche enthält, die in thermischer Nähe zu einer zweiten Wärmeübertragungsfläche eines Wärmeabfuhrelements positionierbar ist, um dazwischen eine Grenzfläche zu definieren, ein Verfahren zum Aufbringen eines Wärme leitenden Phasenumwandlungsmaterials an einer oder beiden der ersten und zweiten Wärmeübertragungsflächen, wobei das Material bei normaler Raumtemperatur in einer ersten Phase formstabil ist und in der Grenzfläche zu der ersten und der zweiten Grenzflächenoberfläche in einer zweiten Phase anpassungsfähig ist, und eine Übergangstemperatur von der ersten Phase zu der zweiten Phase innerhalb des Betriebstemperaturbereichs der elektronischen Komponente hat, wobei das Verfahren folgende Schritte umfasst:
(a) Bereitstellen einer fließenden, härtbaren Zusammensetzung, die eine Mischung aus (I) dem Phasenumwandlungsmaterial und (II) einem Verdünnungsmittel umfasst;
(b) Sprühen der Zusammensetzung von Schritt (a) auf die eine der Wärmeübertragungsflächen, um wenigstens einen Teil davon zu bedecken; und
(c) Härten der Zusammensetzung zur Bildung einer Filmschicht aus dem Phasenumwandlungsmaterial (I) auf der einen der Wärmeübertragungsflächen.

2. Verfahren nach Anspruch 1, des Weiteren umfassend einen zusätzlichen Schritt vor Schritt (b) zur entfernbaren Maskierung der einen der Wärmeübertragungsflächen, um den Spray von Schritt (b) auf eine ausgewählte Fläche zu begrenzen, und wobei die Filmschicht in Schritt (c) mit Rändern gebildet ist, die der ausgewählten Fläche entsprechen.

3. Verfahren nach Anspruch 1, wobei die Zusammensetzung in Schritt (c) durch Verdampfen des Verdünnungsmittels (II) gehärtet wird.

4. Verfahren nach Anspruch 1, wobei die Filmschicht in Schritt (c) mit einer Dicke von weniger als etwa 2 mil (0,05 mm) gebildet wird.

5. Verfahren nach Anspruch 4, wobei die Filmschicht eine Wärmeimpedanz von weniger als etwa 1°C-in²/W (6°C-cm²/W) hat.

6. Verfahren nach Anspruch 1, wobei die Zusammensetzung von Schritt (a) etwa 10 bis 30 Gewichtsprozent Feststoffe hat.

7. Verfahren nach Anspruch 1, wobei das Phasenumwandlungsmaterial (I) von Schritt (a) folgende Komponenten (i) bis (iii), auf das Gewicht bezogen, umfasst:
(i) etwa 25 bis 50 Gewichtsprozent einer druckempfindlichen Acrylhaftmittelkomponente mit einer Schmelztemperatur von etwa 90 bis 100°C;
(ii) etwa 50 bis 75 Gewichtsprozent einer α-olefinischen, thermoplastischen Komponente mit einer Schmelztemperatur von etwa 30 bis 60°C; und
(iii) etwa 20 bis 80 Gewichtsprozent eines oder mehrerer Wärme leitender Füllmittel.

8. Verfahren nach Anspruch 7, wobei das Phasenmaterial (I) eine Phasenübergangstemperatur von etwa 40 bis 80°C hat.

9. Verfahren nach Anspruch 7, wobei das eine oder die mehreren Wärme leitenden Füllmittel ausgewählt sind aus der Gruppe bestehend aus Bornitrid, Titandiborid, Aluminiumoxid, Aluminiumnitrid, Magnesiumoxid, Zinkoxid, Silikoncarbid, Berylliumoxid, Antimonoxid und Mischungen davon.

10. Verfahren nach Anspruch 1, wobei das Wärmeabfuhrelement eine Wärmesenke oder eine Leiterplatte ist.

11. Verfahren nach Anspruch 1, wobei die Schicht in Schritt (c) auf die Wärmeübertragungsfläche der elektronischen Komponente aufgetragen wird.

12. Verfahren nach Anspruch 1, wobei das Verdünnungsmittel (II) ein organisches Lösemittel ist.

13. Verfahren nach Anspruch 12, wobei das Lösemittel Toluol, Xylol, Methylethylketon, Methylisobutylketon, Naphtha oder eine Mischung davon ist.

## Revendications

1. Dans un dispositif comprenant un composant électronique générateur de chaleur ayant un intervalle de température de fonctionnement supérieur à la température ambiante et une première surface de transfert de chaleur positionnable de manière adjacente et thermique à une seconde surface de transfert de chaleur d'un élément de dissipation thermique pour définir un interface entre celles-ci, procédé pour appliquer un matériau à changement de phase conducteur thermiquement à une ou aux deux des première et seconde surfaces de transfert de chaleur, ledit matériau étant stable au niveau de la forme à température ambiante dans une première phase et conforme à l'intérieur de l'interface à la première et la seconde surfaces de l'interface dans une seconde phase, et ayant une température de transition de ladite première phase à ladite seconde phase dans l'intervalle de température de fonctionnement dudit composant électronique, ledit procédé comprenant les étapes de :
(a) apport d'une composition réticulable, fluide comprenant un additif : (I) dudit matériau à changement de phase ; et (II) un diluant ;
(b) pulvérisation de ladite composition de l'étape (a) sur une desdites surfaces de transfert de chaleur pour recouvrir au moins une portion de celles-ci ; et
(c) réticulation de ladite composition pour former une couche en film dudit matériau à changement de phase (I) sur une desdites surfaces de transfert de chaleur.

2. Procédé selon la revendication 1 comprenant en outre une étape supplémentaire précédant l'étape (b) de masquage de manière amovible de l'une desdites surfaces de transfert de chaleur pour confiner la pulvérisation de l'étape (b) à une région sélectionnée de celle-ci, et dans lequel ladite couche en film est formée dans l'étape (c) ayant des marges correspondant à ladite région sélectionnée.

3. Procédé selon la revendication 1 dans lequel ladite composition est réticulée dans l'étape (c) par évaporation dudit diluant (II).

4. Procédé selon la revendication 1 dans lequel ladite couche en film est formée dans l'étape (c) avec une épaisseur inférieure à environ 2 mils (0,05 mm).

5. Procédé selon la revendication 4 dans lequel ladite couche en film a une impédance thermique inférieure à environ 1 °C-in²/W (6°C-cm²/W).

6. Procédé selon la revendication 1 dans lequel ladite composition de l'étape (a) est entre environ 10 et 30 % de solides par unité de poids.

7. Procédé selon la revendication 1, dans lequel ledit matériau à changement de phase (1) de l'étape (a) comprend, en poids des composants (i) à (iii) :
(i) entre environ 25 à 50 % en poids d'une composant autocollant acrylique ayant une température de fusion entre environ 90 à 100°C ;
(ii) entre environ 50 et 75 % en poids d'un composant thermoplastique, -oléfine ayant une température de fusion entre environ 30 et 60°C ; et
(iii) entre environ 20 et 80 % en poids d'une ou plusieurs charges conductrices thermiquement.

8. Procédé selon la revendication 7 dans lequel ledit matériau à changement de phase (1) a une température de transition de phase entre environ 40 et 80°C.

9. Procédé selon la revendication 7 dans lequel ladite une ou plusieurs charges conductrices thermiquement est choisie dans le groupe comprenant le nitrure de bore, le diborure de titane, l'oxyde d'aluminium, le nitrure d'aluminium, l'oxyde de magnésium, l'oxyde de zinc, le carbure de silicium, l'oxyde de béryllium, l'oxyde d'antimoine et des mélanges de ceux-ci.

10. Procédé selon la revendication 1 dans lequel ledit élément de dissipation thermique est un dissipateur thermique ou une carte de circuit.

11. Procédé selon la revendication 1 dans lequel ladite couche est appliquée dans l'étape (c) à la surface de transfert de chaleur dudit composant électronique.

12. Procédé selon la revendication 1 dans lequel ledit diluant (II) est un solvant organique.

13. Procédé selon la revendication 12 dans lequel ledit solvant est du toluène, du xylène, du méthyléthylcétone, du méthylisobutylcétone, du naphta ou un mélange de ceux-ci.
